# EUROPEAN PATENT SPECIFICATION

(11) **EP 0 495 562 B1**
(45) Date of publication and mention of the grant of the patent: **22.07.1998**
(21) Application number: 92250010.3
(22) Date of filing: 11.01.1992
(51) Int. Cl.: H01L 29/772, H01L 21/334, H01L 21/336, H01L 21/76

(54) **Field-effect semiconductor device and method of manufacturing the same**
Feldeffekt-Halbleitervorrichtung und Methode zu deren Herstellung
Dispositif semiconducteur à effet de champ et sa méthode de fabrication

(30) Priority: 14.01.1991 JP 16093/91
(43) Date of publication of application: 22.07.1992
(73) Proprietor: NIPPON TELEGRAPH AND TELEPHONE CORPORATION, Shinjuku-ku, Tokyo 163-19 (JP)
(72) Inventor: Omura, Yasuhisa, Isehara-shi, Kanagawa (JP); Izumi, Katsutoshi, Atsugi-shi, Kanagawa (JP)
(74) Representative: Patentanwälte Wenzel & Kalkoff

(56) References cited:
- EP-A- 405 063
- PATENT ABSTRACTS OF JAPAN vol. 10, no. 370 (E-463)(2427) 10 December 1986 ; & JP-A-61 166 074 ( FUJITSU )
- JOURNAL OF THE ELECTROCHEMICAL SOCIETY vol. 134, no. 6, June 1987, MANCHESTER, NEW HAMPSHIRE US, pp. 1503-1507; K. SAKUMA et al.: 'A new self-aligned planar oxidation technology'
- RESEARCH DISCLOSURE no. 277, May 1987, HAVANT GB, pp. 289-293; 'Lateral epitaxy isolation process'

## Description

### Background of the Invention

The present invention relates to a field-effect semiconductor device and, more particularly, to a field-effect semiconductor device formed on an insulating layer and a method of manufacturing the same.

Fig. 3 shows an example of a conventional field-effect semiconductor device as know for example from JP-A-61-166 074. Referring to Fig. 3, reference numeral 1 denotes a monocrystalline silicon substrate; and 2, an insulating layer formed on this semiconductor substrate. This insulating layer 2 is an insulating film such as a silicon oxide film for electrically insulating an active layer 3 formed on the insulating layer 2 and having a first conductivity type, e.g., a p type from the monocrystalline semiconductor substrate 1. Reference numeral 4 denotes a gate insulating film such as a silicon oxide film; 5, a source region of a second conductivity type, e.g., an n type; and 6, a drain region of the second conductivity type, i.e., the n type. The source region 5, the active layer 3, and the drain region 6 are arranged adjacent to each other in the order named on the insulating film 2. Reference numeral 7 denotes a gate electrode arranged on the gate insulating film 4 corresponding to the active layer 3; 8a, 8b, and 8c, insulating films to electrically insulate interconnecting layers; 9, a source electrode; and 10, a drain electrode.

In a semiconductor device of this type, the impurity concentration of the active layer 3 is designed such that the thickness of a depletion layer which may expand from the gate electrode side is larger than the thickness to of the active layer 3, and consequently the entire region of the active layer is depleted when the semiconductor device is in operation. The reasons for this arrangement are: (1) the mobility deterioration of surface carriers below the gate insulating film 4 can be suppressed by reducing the effective electric field strength in the active layer, and thereby the drain current can be increased, and (2) the drain current can increase with an increase in such carriers (at inverted surface) in in the active layer, corresponding to a reduction in a charge amount in the depletion layer formed. In addition, in a semiconductor device having the above arrangement, since the active layer 3 is depleted by a gate-induced electric field, it is possible to suppress an incursion of a drain electric field from a drain junction into the active layer 3, and in this manner the short channel effect in a threshold voltage can be suppressed. Accordingly, a semiconductor device of this the is expected to realize both a high-density integration of a semiconductor device obtained by down scaling in dimensions and a high-speed operation and therefore has attracted attention as a promising device in recent years.

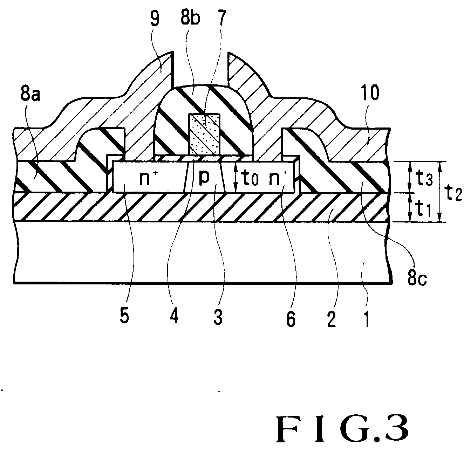

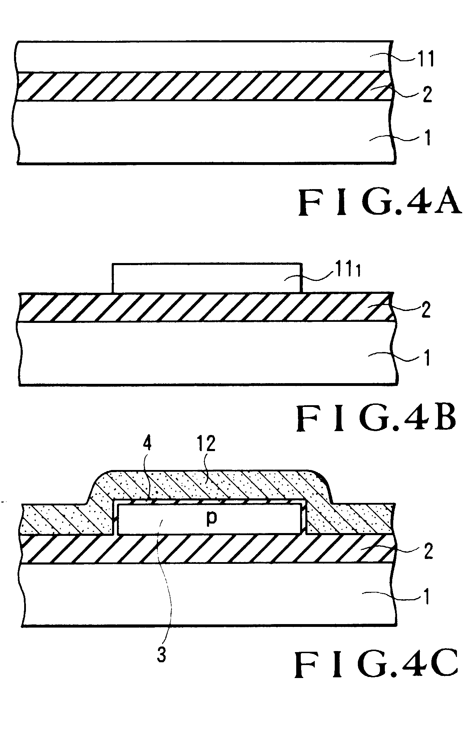

Figs. 4A to 4E show a practical example of a method of manufacturing the semiconductor device shown in Fig. 3.

First, as shown in Fig. 4A, a silicon oxide film 2 is buried in, e.g., a monocrystalline silicon semiconductor 1, and a first silicon semiconductor layer 11 is formed on the silicon oxide film 2, thereby preparing a silicon semiconductor structure. This semiconductor structure is formed by implanting oxygen ions into, e.g., a monocrystalline semiconductor.

Subsequently, as shown in Fig. 4B, the first semiconductor layer 11 on the major surface side of the semiconductor structure is formed into predetermined dimensions by, e.g., an anisotropic plasma etching technique, thus forming a silicon semiconductor layer 11₁.

As shown in Fig. 4C, a predetermined impurity is doped into the silicon semiconductor region 11₁ by, e.g., an ion-implantation technique to form an active layer 3 of a first conductivity type (p type). Thereafter, a silicon oxide film 4 as a gate insulating film, for example, is formed on the active layer 3, and subsequently a doped silicon layer 12, for example, as a gate electrode is deposited.

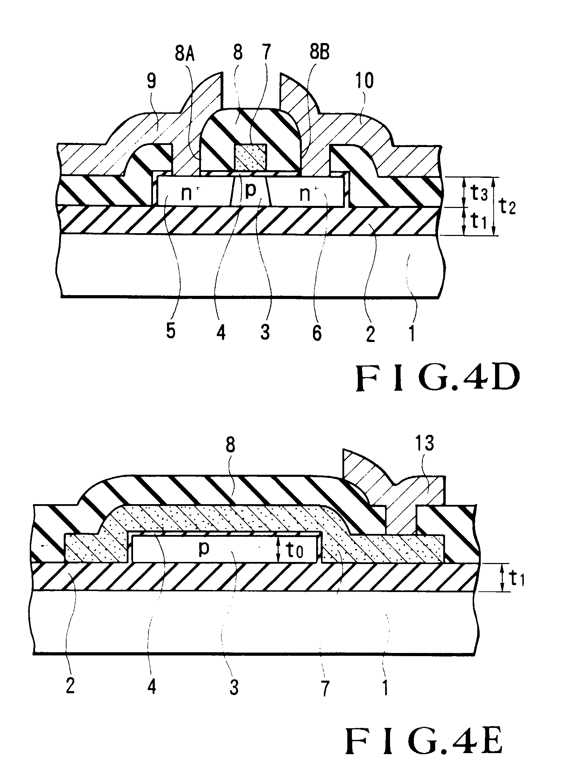

As shown in Fig. 4D, the gate electrode silicon layer 12 is formed into predetermined dimensions by, e.g., the anisotropic plasma etching technique to form a gate electrode 7. Thereafter, a source region 5 of a second conductivity type (n type) and a drain region 6 of the same conductivity type are formed by, e.g., the ion-implantation technique. An insulating film 8, such as a silicon oxide film, is deposited on the major surface side of the semiconductor substrate, contact holes 8A and 8B are formed on the source region 5 and the drain region 6, and a metal layer as an electrode interconnection is deposited. Thereafter, this metal layer is processed to form a source electrode 9 and a drain electrode 10.

Note that Fig. 4E shows a section obtained by cutting the gate of the semiconductor device shown in Fig. 4D in a direction perpendicular to the drawing surface, in which reference numeral 13 denotes an interconnection for connecting the gate electrode 7 to another device.

A further prior art method is known from EP-A-0 405 063.

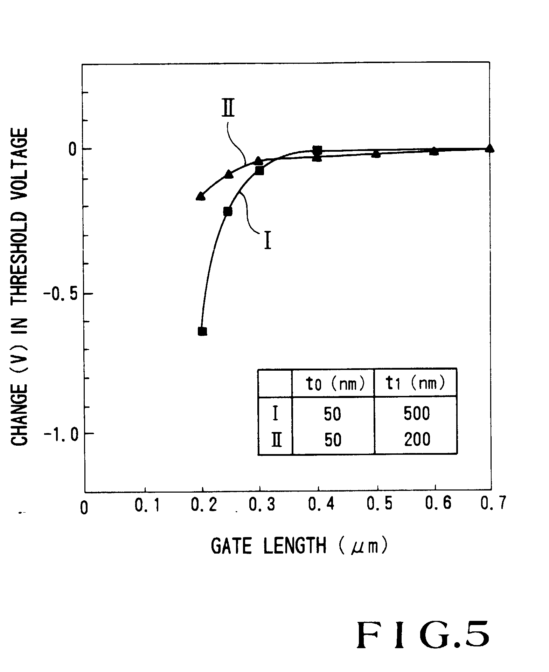

Fig. 5 shows the results obtained by measuring the relationship between the threshold voltage and the gate length in a semiconductor device of this type actually manufactured by the method as described above. That is, Fig. 5 shows the relationship between the change in threshold voltage and the gate length on the basis of the threshold voltage of a semiconductor device with a gate length of 0.7 µm. Referring to Fig. 5, t₀ indicates the thickness of the silicon active layer 3 of the semiconductor device used in the measurement, and t₁ (shown in Fig. 4E) indicates the thickness of the silicon oxide film 2 arranged below the active layer 3. Note that in Fig. 5, curve I represents the result obtained when t₀ = 50 (nm) and t₁ = 500 (nm), and curve II represents the result obtained when t₀ = 50 (nm) and t₁ = 200 (nm). Fig. 5 reveals that when the thickness t₁ of the silicon oxide film 2 is small, the change in threshold voltage is also small if the gate channel length is shortened, and in this manner the short channel effect is suppressed. Therefore, in order to realize down scaling of a semiconductor device of this type, it is essential to decrease the thickness of the silicon oxide film 2.

When the thickness t₁ of the silicon oxide film decreases, however, (1) the parasitic capacitance at the drain region 6 of the semiconductor device increases. In addition, (2) in the conventional manufacturing method as described above, the thickness t₂ of the insulating film located below the electrode interconnection shown in Fig. 4D decreases. This decrease in thickness results in a large increase in parasitic capacitance at interconnections for connecting semiconductor devices upon integration of the devices, and this makes it difficult to realize a high-speed operation of the semiconductor device. Note that it is clear from computations that the increase in parasitic capacitance described in item (1) above actually has no influence on realization of a high-speed operation if the thickness t₁ of the silicon oxide film 2 is 10 times or more the thickness of the silicon oxide film 4 as a gate insulating film.

On the other hand, since the interconnection length in an LSI circuit reaches about 1 cm, the increase in parasitic capacitance below the interconnection has a large influence on the operating speed of the circuit. In addition, as shown in Fig. 4E, in order to form the interconnection 13 for connecting the gate electrode 7 to another device, the gate electrode must be excessively extracted onto the insulating film 2. When the thickness t₁ of the insulating film 2 decreases, the parasitic capacitance of this portion becomes too large to be neglected and adversely affects the operating speed of the device.

A field-effect semiconductor device of this type, therefore, has not been put into practical use yet because it has the problems as described above as well as several good characteristics.

### Summary of the Invention

It is, therefore, a principal object of the present invention to provide a field-effect semiconductor device and a method of manufacturing the same, in which the parasitic capacitance in an interconnection for connecting a gate electrode to another interconnection can be suppressed to increase the operating speed.

It is another object of the present invention to provide a field-effect semiconductor device and a method of manufacturing the same, in which the capacitance in interconnections for connecting field-effect semiconductor devices can be suppressed to increase the operating speed.

It is still another object of the present invention to provide a field-effect semiconductor device and a method of manufacturing the same, in which down scaling of the device is realized as well as the above objects.

It is still another object of the present invention to provide a field-effect semiconductor device and a method of manufacturing the same, in which even when the thickness of an insulating layer arranged below an active layer of the device is decreased to reduce the short channel effect, increases in parasitic capacitance and interconnection capacitance of the semiconductor device can be suppressed to realize a high-speed operation even in an LSI circuit.

It is still another object of the present invention to provide a field-effect semiconductor device and a method of manufacturing the same, which can achieve the above objects by performing a self-alignment technique after lithography is performed only once.

In order to achieve the above objects, in the present invention, a non-oxidizable insulating film is arranged on at least almost the entire region on the major surface side except for the upper surface of an active layer.

According to the first aspect of the present invention, therefore, there is provided a field-effect semiconductor device comprising a first insulating film formed on a semiconductor substrate, a source region of a second conductivity type and a drain region of the second conductivity type, which are arranged on the insulating film and are formed on both the sides of a semiconductor active layer of a first conductivity type, a second insulating film for covering top and side surfaces of the semiconductor active layer, the source region, and the drain region, a gate electrcde arranged on the second insulating film corresponding to the semiconductor active layer, a non-oxidizable third insulating film arranged on the second insulating film for covering the first insulating film and the side surfaces of the semiconductor active layer and the source and drain regions, a fourth insulating film arranged on the non-oxidizable third insulating film except for a portion thereof located on the side surfaces of said source and drain regions, a fifth insulating film for covering said portion of the third insulating film located on the side surfaces of the source and drain regions, the fourth insulating film, the semiconductor active layer, the second insulating film arranged on the top surfaces of the source and drain regions, and said gate electrode arranged on the second insulating film, and a source electrode and a drain electrode arranged on the fifth insulating film and connected to the source region and the drain region, respectively, through contact holes formed in the fifth insulating film and the second insulating film.

According to another aspect of the present invention, there is provided a method of manufacturing the above described a field-effect semiconductor device, comprising the steps of preparing a semiconductor structure in which a first insulating film is formed on a semiconductor substrate and a first semiconductor layer is formed on the first insulating layer, processing the first semiconductor layer to have predetermined planar dimensions, forming a second insulating film on top and side surfaces of the processed first semiconductor layer, depositing a third non-oxidizable insulating film on a major surface of the semiconductor structure, depositing a second semiconductor layer on the third non-oxidizable insulating film, forming a fourth insulating film on the second semiconductor layer, depositing a fifth non-oxidizable insulating film on the fourth insulating film, processing the fifth non-oxidizable insulating film to have dimensions covering the region of the first semiconductor layer processed into predetermined planar dimensions, oxidizing the second semiconductor layer by using the fifth non-oxidizable insulating film as a mask, thereby changing a major region into a semiconductor oxide, removing the fifth non-oxidizable insulating film and the fourth insulating film remaining under the fifth non-oxidizable insulating film to expose the second semiconductor layer remaining under the fourth insulating film, etching the second semiconductor layer to expose the third non-oxidizable insulating film on the processed first semiconductor layer, changing the second semiconductor layer partially remaining on a periphery of the processed first semiconductor layer into an oxide, and etching the third non-oxidizable insulating film exposed on a major surface side of the semiconductor structure to expose the second insulating film.

### Brief Description of the Drawings

Figs. 1A to 1K are sectional views showing an embodiment of a field-effect semiconductor device according to the present invention and a method of manufacturing the same;
Fig. 1L is a view showing a section obtained by cutting the gate electrode of the semiconductor device shown in Fig. 1K in a direction (1J - 1J') perpendicular to the drawing surface;
Fig. 2 is a sectional view showing a state in which the field-effect semiconductor device of the present invention is actually incorporated in an integrated circuit;
Fig. 3 is a sectional view showing an example of a conventional field-effect semiconductor device;
Figs. 4A to 4D are sectional views showing an example of a method of manufacturing the conventional semiconductor device;
Fig. 4E is a view showing a section obtained by cutting the gate electrode of the semiconductor device of Fig. 4D in a direction perpendicular to the drawing surface; and
Fig. 5 is a graph showing the results obtained by measuring the relationship between the threshold voltage and the gate length of a semiconductor device of this type actually manufactured by a conventional method.

### Detailed Description of the Preferred Embodiments

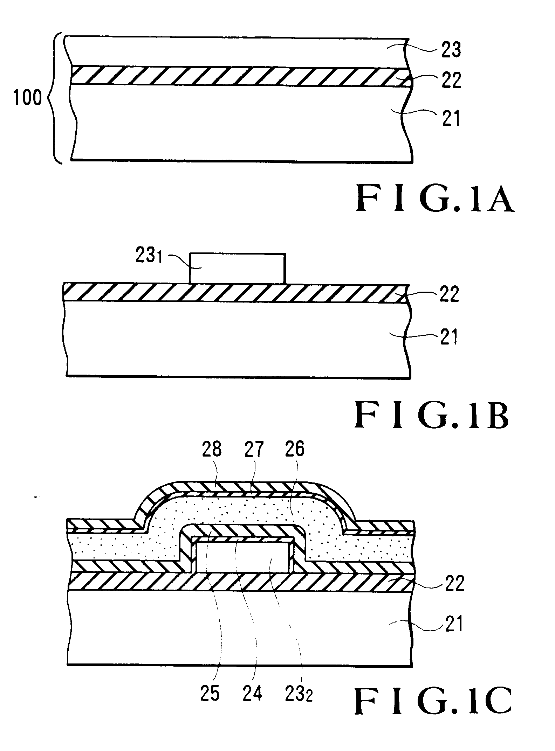

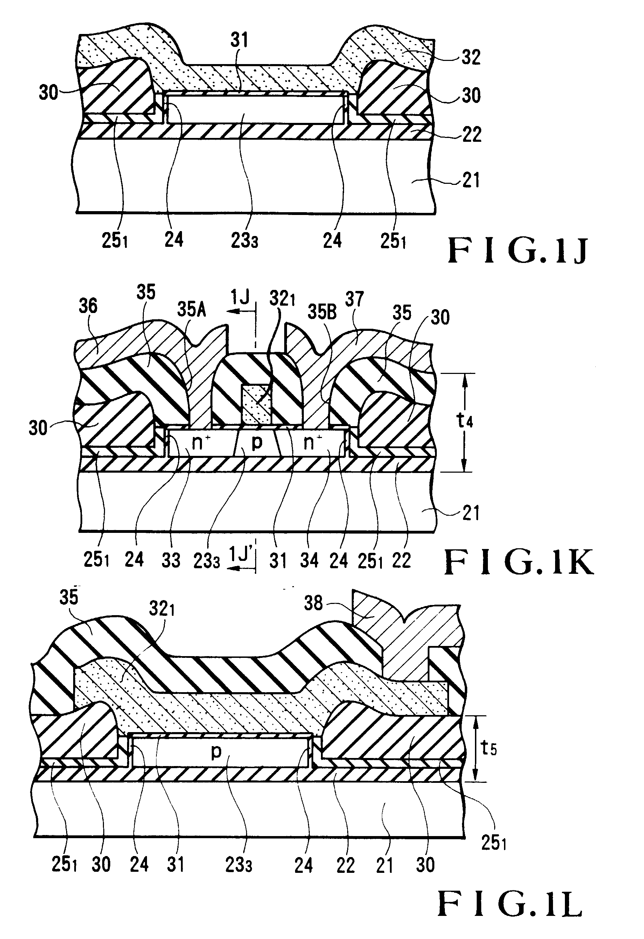

Figs. 1A to 1L show an embodiment of a field-effect semiconductor device according to the present invention and a method of manufacturing the same.

The method of manufacturing the field-effect semiconductor device of the present invention will be described below with reference to Figs. 1A to 1L. First, as shown in Fig. 1A, an insulating layer, e.g., a silicon oxide layer 22 having a thickness of 100 nm is buried in a monocrystalline silicon semiconductor 21, and a first silicon semiconductor layer 23 having a thickness of 100 nm is formed on this insulating layer, thereby preparing a semiconductor structure 100. In this case, the silicon oxide layer 22 is formed by implanting oxygen ions into the monocrystalline silicon semiconductor. Such a semiconductor structure can be formed by forming an insulating film on a silicon substrate and forming a monocrystalline semiconductor layer by bonding.

Subsequently, as shown in Fig. 1B, the first semiconductor layer 23 is subjected to an anisotropic etching technique, e.g., a reactive ion-etching technique to form a region 23₁ serving as a semiconductor active layer. In this case, the RF power density is 5 to 6 W/cm², the gas used is Cl₂, the pressure is 10 Pa, and the etching time is five minutes.

As shown in Fig. 1C, a silicon oxide film 24 is formed on the region 23₁ serving as a semiconductor active layer by performing, e.g., thermal oxidation on the surface of the region 23₁. In this case, the oxide film 24 is formed to have a thickness of 10 nm by supplying 5 ℓ/min of oxygen at 900°C for 30 minutes. Subsequently, a non-oxidizable insulating film 25, such as a silicon nitride film, is deposited on the major surface side of the semiconductor substrate, and a silicon semiconductor film 26, for example, is deposited on the insulating film 25. An insulating film 27 is formed by oxidizing the surface of the semiconductor film 26, and a non-oxidizable insulating film 28, such as a silicon nitride film, is deposited on the insulating film 27. In this case, the silicon nitride films 25 and 28 are formed through a low pressure CVD method to have thicknesses of 100 nm and 150 nm, respectively, in an NH₃ + SiH₂Cl₂ gas atmosphere at 850°C for 40 minutes and 60 minutes, respectively. The silicon semiconductor film 26 is similarly formed by the low pressure CVD method. However, the gas used is SiH₄, and the film is formed to have a thickness of 100 nm at 600°C for 10 minutes. The insulating film 27 is formed to have a thickness of 10 nm by supplying 5 ℓ/min of oxygen at 900°C for 30 minutes.

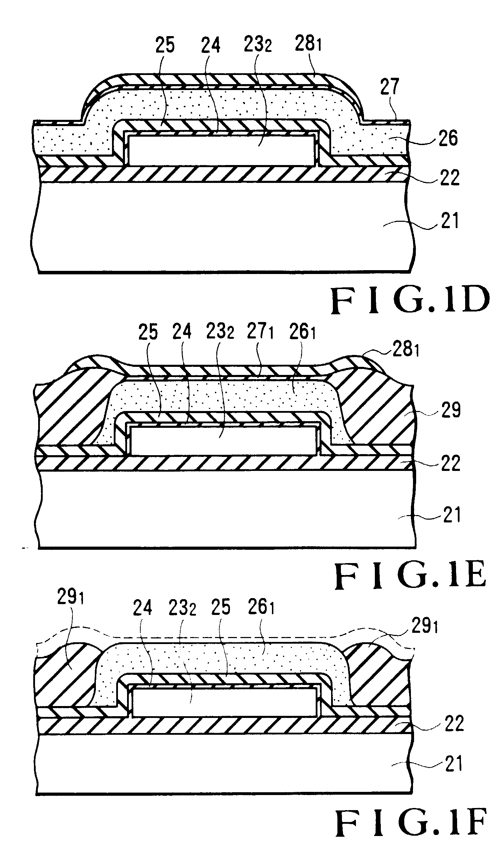

Subsequently, as shown in Fig. 1D, the insulating film 28 is processed to form an insulating film 28₁ such that the semiconductor active layer covered with the insulating film 24 cannot be seen when viewed from above, i.e., when viewed from above onto the major surface side of the semiconductor substrate. A reactive ion-etching technique is used as the etching technique for this insulating film 28. The etching is performed under the conditions of, for example, RF power density = 0.1 to 0.15 W/cm², flow rate ratio of CF₄ + H₂ gases = 65 : 35, pressure = 3 Pa, and temperature = room temperature. During the etching, in this embodiment, the insulating film 27 is exposed on portions where no insulating film 28 is present.

As shown in Fig. 1E, the exposed portions of the insulating film 27 are removed by etching, and the resulting exposed semiconductor layer 26 is oxidized to the interface between the semiconductor layer 26 and the insulating film 25 through a self-alignment technique by using the insulating film 28₁ as a mask, thereby forming a silicon oxide film 29. In this case, the oxidation of the semiconductor layer 26 is performed by, e.g., a hydrogen combustion oxidizing method by supplying H₂ (3 ℓ/min) + O₂ (5 ℓ/min) gases at a temperature of 900°C for 120 minutes. Note that in this step, if the insulator 27 consists of a silicon oxide film, the insulator 27 need not be removed but the major surface side of the semiconductor substrate may be directly exposed to an oxygenous ambient to oxidize the semiconductor layer 26.

Next, as shown in Fig. 1F, the insulating film 28₁ is removed, and subsequently an insulating film 27₁ remaining on a semiconductor layer 26₁ is removed to expose the semiconductor layer 26₁. In this case, the removal of the silicon nitride film 28 is performed through etching by dipping the substrate in phosphoric acid (160°C) for 60 minutes.

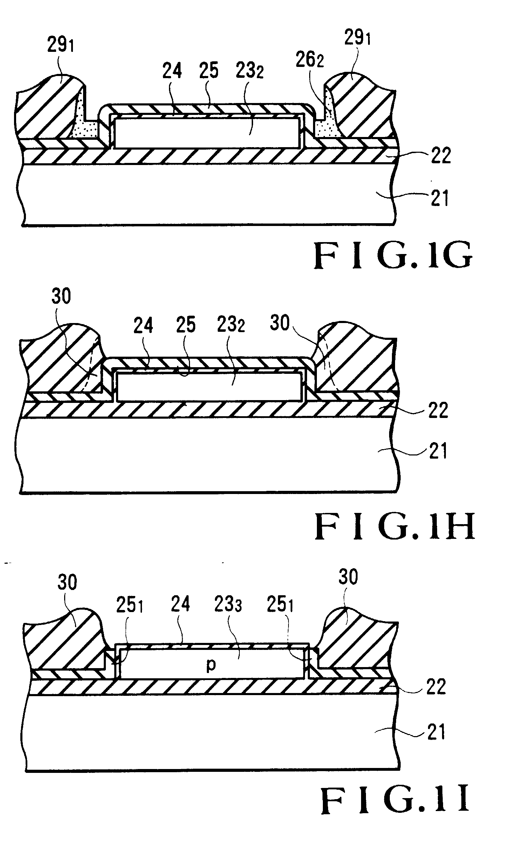

As shown in Fig. 1G, the remaining semiconductor layer 26₁ is etched by a reactive ion-etching technique with strong anisotropy until the insulating film 25 on a region 23₂ is exposed. As a result, a semiconductor layer 26₂ remains only around the semiconductor layer 23₂, particularly on a portion adjacent to most of the side walls. In this case, an ECR stream etching technique, for example, is performed as the etching, and the reaction is caused under the conditions of RF power density = 5 to 6 W/cm², gas used = Cl₂, and pressure = 10 Pa, for five minutes.

Subsequently, as shown in Fig. 1H, the major surface side of the semiconductor substrate is thermally oxidized to change most of the semiconductor layer 26₂ into a silicon oxide 30. In this stage, the semiconductor layer 26₂, together with a silicon oxide film 29₁ located around the semiconductor layer 26₂, is changed into the silicon oxide, and consequently almost the entire portion around the semiconductor active layer becomes an insulator. In this case, the oxidation is performed through, e.g., a hydrogen combustion oxidizing method by supplying H₂ (3 ℓ/min) + O₂ (5 ℓ/min) gases at a temperature of 900°C for 60 minutes.

As shown in Fig. 1I, the exposed portion of the insulating film 25 is etched away to expose the insulating film 24. Thereafter, an impurity is doped into the semiconductor active layer 23₂ by, e.g., an ion-implantation technique to impart a first conductivity type to a semiconductor active layer 23₃. In this case, the removal of the silicon nitride film 25 is performed through etching by dipping the substrate into phosphoric acid (160°C) for 40 minutes.

Subsequently, as shown in Fig. 11, after the insulating film 24 is removed, the exposed surface of the semiconductor active layer 23₃ is oxidized to form a gate oxide film 31, and a doped silicon semiconductor layer 32 to be used as a gate electrode is deposited on the major surface side of the semiconductor substrate.

Next, as shown in Fig. 1K, the semiconductor layer 32 is processed into predetermined dimensions to form a gate electrode 32₁, and a source region 33 of a second conductivity type (n⁺) and a drain region 34 of the same conductivity type are formed by, e.g., the ion-implantation technique. Thereafter, an insulating film 35 is deposited on the major surface side of the semiconductor substrate, and contact holes 35A and 35B are formed on the source and drain regions, respectively. Lastly, a source electrode 36 and a drain electrode 37 are formed.

Fig. 1L shows a cross section obtained by cutting the gate electrode of the semiconductor device shown in Fig. 1K in the direction of line 1J - 1J', i.e., in the direction of gate width. In the conventional manufacturing method shown in Fig. 4E, the thickness t₁ of the insulating film is very thin in a portion where the gate electrode silicon film 7 extends from the active region, and this unnecessarily increases the parasitic capacitance of the gate. By contrast, as shown in Fig. 1L according to the manufacturing method of the present invention, the thickness t₅ of the insulating film in a portion where the gate electrode silicon film 32₁ extends from the active region is the total thickness of the layers 30, 25₁, and 22. As a result, since the total thickness of the insulating films in this portion is much larger than that in the conventional structure, it is possible to drastically decrease the parasitic capacitance of the gate. Note that in Fig. 1L, reference numeral 38 denotes a gate extracting electrode for connecting the gate electrode 32₁ to another device.

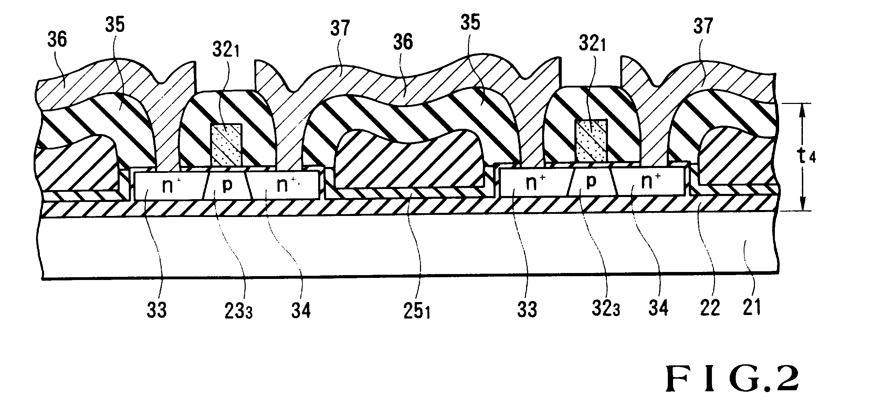

Fig. 2 shows an embodiment of a semiconductor device manufactured by the manufacturing method of the present invention. Referring to Fig. 2, a plurality of semiconductor devices are formed on an insulating film 22 and electrically connected with each other. It is apparent from this structure that the semiconductor device of the present invention can be easily applied to an LSI circuit.

The characteristic feature of the manufacturing method of the present invention is that a non-oxidizable insulating film (e.g., a silicon nitride film) 25₁ is arranged on the entire surface of the insulating film 22 except for an active region of a semiconductor device, and that this non-oxidizable insulating film 25₁ is arranged on all side surfaces except for the top surface of the active layer. This arrangement is adopted for the reasons to be explained below.

That is, in conventional techniques, an active layer is electrically isolated by forming it to have an island-like shape, as shown in Fig. 4B. As a method of isolating an active layer, on the other hand, there is a conventionally known method in which, in Fig. 4B, a non-oxidizable insulating film having a predetermined planar shape is formed on a semiconductor layer 11₁ and a semiconductor substrate is then exposed to an oxygenous ambient so that an exposed region of the semiconductor layer is replaced with an oxide film (selective oxidation: LOCOS technique).

In this method, however, when the semiconductor layer 11₁ is oxidized in the direction of thickness, it is practically difficult to stop the oxidation exactly when the front surface of the oxidation reaction reaches the buried insulating film 22. This is because extra oxidation is required because a variation in thickness of the semiconductor layer on the semiconductor substrate and a variation in oxidation rate are always present. Therefore, in active layers of some semiconductor devices, lateral oxidation progresses due to lateral diffusion of oxygen through the buried insulating film in the end portion of the active layer, and the oxidation progresses from the bottom of the end portion of-the active layer. As a result, the active layer is subjected to the tension of the oxide film from its bottom surface, and this deteriorates the electrical characteristics. The progress of the lateral oxidation is also a problem in terms of miniaturization of the active layer. For these reasons, the active layer region isolating method using the selective oxidation is not applied.

As has been described above, the following effects can be obtained according to the present invention.
i) Even when a semiconductor device is formed by using a semiconductor substrate having a thin buried oxide film, a region surrounding an active layer of the semiconductor device can be constituted by a relatively thick insulating film. Therefore, it is possible to prevent an increase in parasitic capacitance in a portion where a gate electrode extends from the active region, so that the operating speed of the integrated circuit can be increased.
ii) Even in a case in which a semiconductor device is formed by using a semiconductor substrate having a thin buried oxide film, a region surrounding an active layer of the semiconductor device can be constituted by a relatively thick insulating film. Therefore, an increase in capacitance of interconnections for connecting circuits can be prevented, and this increases the operating speed of the integrated circuit.
iii) Semiconductor device manufacturing techniques which have been conventionally developed can be applied directly to the manufacturing method of the present invention. In addition, this manufacturing method does not involve any step having technical difficulty and requires only one self-alignment process.

## Claims

1. A field-effect semiconductor device comprising:
a first insulating film (22) formed on a semiconductor substrate;
a source region (33) of a second conductivity type and a drain region (34) of the second conductivity type, which are arranged on said insulating film and are formed on both the sides of a semiconductor active layer (23₃) of a first conductivity type;
a second insulating film (24, 31) for covering top and side surfaces of said semiconductor active layer, said source region, and said drain region;
a gate electrode (32₁) arranged on said second insulating film (31) corresponding to said semiconductor active layer (23₃);
a non-oxidizable third insulating film (25₁) arranged on said second insulating film for covering the first insulating film and the side surfaces of said semiconductor active layer and said source and drain regions;
a fourth insulating film (30) arranged on said non-oxidizable third insulating film except for a portion thereof located on the side surfaces of said source and drain regions;
a fifth insulating film (35) for covering said portion of said third insulating film located on the side surfaces of said source and drain regions, said fourth insulating film, said semiconductor active layer, said second insulating film arranged on the top surfaces of said source and drain regions, and said gate electrode arranged on said second insulating film; and
a source electrode (36) and a drain electrode (37) arranged on said fifth insulating film and connected to said source region and said drain region, respectively, through contact holes (35A, 35B) formed in said fifth insulating film and said second insulating film.

2. A device according to claim 1, wherein each of said first, second, fourth, and fifth insulating films is a silicon oxide film, and said third insulating film is a silicon nitride film.

3. A device according to claim 1 or 2, wherein said third insulating film extends to another adjacent element.

4. A method of manufacturing a field-effect semiconductor device, according to any one of claims 1 to 3 comprising the steps of:
preparing a semiconductor structure (100) in which a first insulating film (22) is formed on a semiconductor substrate (21) and a first semiconductor layer (23) is formed on said first insulating layer;
processing said first semiconductor layer to have predetermined planar dimensions;
forming a second insulating film (24) on top and side surfaces of said processed first semiconductor layer (23₁);
depositing a third non-oxidizable insulating film (25) on a major surface of said semiconductor structure (100);
depositing a second semiconductor layer (26) on said third non-oxidizable insulating film (25);
forming a fourth insulating film (27) on said second semiconductor layer (26);
depositing a fifth non-oxidizable insulating film (28) on said fourth insulating film (27);
processing said fifth non-oxidizable insulating film (28) to have dimensions covering the region of said first semiconductor layer processed into predetermined planar dimensions;
oxidizing said second semiconductor layer by using said fifth non-oxidizable insulating film as a mask, thereby changing a major region into a semiconductor oxide (29);
removing said fifth non-oxidizable insulating film (28) and said fourth insulating film (27₁) remaining under said fifth non-oxidizable insulating film to expose said second semiconductor layer (26₁) remaining under said fourth insulating film;
etching said second semiconductor layer (26₁) to expose said third non-oxidizable insulating film (25) on said processed first semiconductor layer (23₂);
changing said second semiconductor layer partially remaining on a periphery of said processed first semiconductor layer (23₂) into an oxide (30); and
etching said third non-oxidizable insulating film (25) exposed on a major surface side of said semiconductor structure to expose said second insulating film (24).

5. A method according to claim 4, further comprising the steps of:
changing said first semiconductor layer into a semiconductor active layer (23₃) of a first conductivity type;
removing said second insulating film (24) on said semiconductor active layer to form a gate oxide film (31);
forming a gate electrode (32₁) on said semiconductor active layer (23₃) and forming an interconnection layer for connecting said gate electrode to another element;
forming an insulating layer (35) on said semiconductor structure; and
forming a source electrode and a drain electrode connected to a source region and a drain region, respectively, through contact holes (35A, 35B) formed in said insulating layer (35) and said gate oxide film arranged below said insulating layer.

6. A method according to claim 4 or 5, wherein after said fifth non-oxidizable insulating film (28) is processed into predetermined planar dimensions, said exposed fourth insulating film is removed to expose said second semiconductor layer (26) under said fourth insulating film.

## Patentansprüche

1. Eine Feldeffekt-Halbleitervorrichtung umfassend:
eine erste Isolierschicht (22), die auf einem Halbleitersubstrat gebildet ist;
einen Source-Bereich (33) eines zweiten Leitfähigkeitstyps und einen Drain-Bereich (34) des zweiten Leitfähigkeitstyps, die auf der Isolierschicht angeordnet und auf beiden Seiten einer Halbleiter-Aktivschicht (23₃) eines ersten Leitfähigkeitstyps angeordnet sind;
eine zweite Isolierschicht (24, 31) zum Abdecken der Ober- und Seitenflächen der Halbleiter-Aktivschicht, des Source-Bereichs und des Drain-Bereichs;
eine Gate-Elektrode (32₁), die auf der zweiten Isolierschicht (31) entsprechend der Halbleiter-Aktivschicht (23₃) angeordnet ist;
eine nicht-oxidierbare dritte Isolierschicht (25₁), die auf der zweiten Isolierschicht zum Abdecken der ersten Isolierschicht und der Seitenflächen der Halbleiter-Aktivschicht und der Source- und Drain-Bereiche angeordnet ist;
eine vierte Isolierschicht (30), die auf der nicht-oxidierbaren dritten Isolierschicht mit Ausnahme eines Teils derselben, der sich auf den Seitenflächen der Source- und Drain-Bereiche befindet, angeordnet ist;
eine fünfte Isolierschicht (35) zum Abdecken besagten Bereichs der dritten Isolierschicht, die sich auf den Seitenflächen der Source- und Drainbereiche, der vierten Isolierschicht, der Halbleiter-Aktivschicht, der zweiten, auf den Oberflächen der Source- und Drainbereiche angeordneten zweiten Isolierschicht und der auf der zweiten Isolierschicht angeordneten Gate-Elektrode befindet; und
eine Source-Elektrode (36) und eine Drain-Elektrode (37), die auf der fünften Isolierschicht angeordnet und mit dem Source-Bereich bzw. dem Drain-Bereich durch Kontaktlöcher (35A, 35B) verbunden sind, die in der fünften Isolierschicht und der zweiten Isolierschicht ausgebildet sind.

2. Eine Vorrichtung nach Anspruch 1, bei der jede der ersten, zweiten, vierten und fünften Isolierschichten eine Siliciumoxidschicht und die dritte Isolierschicht eine Siliciumnitridschicht ist.

3. Eine Vorrichtung nach Anspruch 1 oder 2, bei der die dritte Isolierschicht sich auf ein weiteres benachbartes Element erstreckt.

4. Ein Verfahren zum Herstellen einer Feldeffekt-Halbleitervorrichtung gemäß einem der Ansprüche 1 bis 3, umfassend die Schritte:
Bereitstellen einer Halbleiterstruktur (100), in der eine erste Isolierschicht (22) auf einem Halbleitersubstrat (21) und eine erste Halbleiterschicht (23) auf der ersten Isolierschicht gebildet werden;
Bearbeiten der ersten Halbleiterschicht zur Erzeugung vorbestimmter planarer Dimensionen;
Ausbilden einer zweiten Isolierschicht (24) auf Ober- und Seitenflächen der bearbeiteten ersten Halbleiterschicht (23₁);
Ablagern einer dritten nicht-oxidierbaren Isolierschicht (25) auf einer Hauptfläche der Halbleiterstruktur (100);
Ablagern einer zweiten Halbleiterschicht (26) auf der dritten nicht-oxidierbaren Isolierschicht (25);
Ausbilden einer vierten Isolierschicht (27) auf der zweiten Halbleiterschicht (26);
Ablagern einer fünften nicht-oxidierbaren Isolierschicht (28) auf der vierten Isolierschicht (27);
Bearbeiten der fünften nicht-oxidierbaren Isolierschicht (28) zur Schaffung von Dimensionen, die den Bereich der ersten Halbleiterschicht, die auf die vorbestimmten planaren Dimensionen bearbeitet ist, abdecken;
Oxidieren der zweiten Halbleiterschicht durch Verwendung der fünften nicht-oxidierbaren Isolierschicht als Maske, wodurch ein Hauptbereich in ein Halbleiteroxid (29) geändert wird;
Entfernen der fünften nicht-oxidierbaren Isolierschicht (28) und der vierten Isolierschicht (27₁), die unter der fünften nicht-oxidierbaren Isolierschicht verbleibt, zum Freilegen der zweiten Halbleiterschicht (26₁), die unter der vierten Isolierschicht verbleibt;
Ätzen der zweiten Halbleiterschicht (26₁) zum Freilegen der dritten nicht-oxidierbaren Isolierschicht (25) auf der bearbeiteten ersten Halbleiterschicht (23₂);
Ändern der zweiten Halbleiterschicht, die teilweise auf der Peripherie der bearbeiteten ersten Halbleiterschicht (23₂) verbleibt, in ein Oxid (30); und
Ätzen der dritten nicht-oxidierbaren Isolierschicht (25), die auf einer Hauptoberflächenseite der Halbleiterstruktur freigelegt ist, um die zweite Isolierschicht (24) freizulegen.

5. Ein Verfahren nach Anspruch 4, weiter umfassend die Schritte:
Ändern der ersten Halbleiterschicht in eine Halbleiter-Aktivschicht (23₃) eines ersten Leitfähigkeitstyps;
Entfernen der zweiten Isolierschicht (24) auf der Halbleiter-Aktivschicht zur Bildung einer Gate-Oxidschicht (31);
Bilden einer Gate-Elektrode (32₁) auf der Halbleiter-Aktivschicht (23₃) und Ausbilden einer Zwischenverbindungsschicht zur Verbindung der Gate-Elektrode mit einem weiteren Element;
Ausbilden einer Isolierschicht (35) auf der Halbleiterstruktur; und
Ausbilden einer Source-Elektrode und einer Drain-Elektrode, verbunden mit einem Source-Bereich bzw. einem Drain-Bereich, durch Kontaktlöcher (35A, 35B), die in der Isolierschicht (35) und der Gate-Oxidschicht, die unter der Isolierschicht angeordnet ist, gebildet sind.

6. Ein Verfahren nach Anspruch 4 oder 5, bei dem nach dem Bearbeiten der fünften nicht-oxidierbaren Isolierschicht (28) in vorbestimmte planare Dimensionen die freigelegte vierte Isolierschicht entfernt wird, um die zweite Halbleiterschicht (26) unter der vierten Isolierschicht freizulegen.

## Revendications

1. Dispositif semi-conducteur à effet de champ comprenant:
un premier film isolant (22) formé sur un substrat semi-conducteur;
une région source (33) d'un second type de conductivité et une région de drain (34) du second type de conductivité, qui sont disposées sur ledit film isolant et sont formées sur les deux côtés d'une couche active semi-conductrice (23₃) d'un premier type de conductivité;
un second film isolant (24, 31) pour recouvrir les surfaces de sommet et de côté de ladite couche active semi-conductrice, ladite région de source et ladite région de drain;
une électrode de grille (32₁) disposée sur ledit second film isolant (31) correspondant à ladite couche active semi-conductrice (23₃);
un troisième film isolant non oxydable (25₁) disposé sur ledit second film isolant pour recouvrir le premier film isolant, et les surfaces latérales de ladite couche active semi-conductrice et desdites régions de source et de drain;
un quatrième film isolant (30) disposé sur ledit troisième film isolant non oxydable, à l'exception d'une de ses parties située sur les surfaces latérales desdites régions de source et de drain;
un cinquième film isolant (35) pour recouvrir ladite partie dudit troisième film isolant située sur les surfaces latérales desdites régions de source et de drain, ledit quatrième film isolant, ladite couche active semi-conductrice, ledit second film isolant disposé sur les surfaces de sommet desdites régions de source et de drain, et ladite électrode de grille disposée sur ledit second film isolant; et
une électrode source (36) et une électrode drain (37) disposées sur ledit cinquième film isolant et connectées à ladite région source et à ladite région drain, respectivement, à travers des trous de contact (35A, 35B) formés dans ledit cinquième film isolant et ledit second film isolant.

2. Dispositif selon la revendication 1, dans lequel chacun des premier, second, quatrième et cinquième films isolants est un film d'oxyde de silicium, et ledit troisième film isolant est un film de nitrure de silicium.

3. Dispositif selon la revendication 1 ou 2, dans lequel ledit troisième film isolant s'étend en direction d'un autre élément adjacent.

4. Procédé de fabrication d'un dispositif semi-conducteur à effet de champ conforme à l'une quelconque des revendications 1 à 3, comprenant les étapes consistant à :
préparer une structure semi-conductrice (100), dans laquelle un premier film isolant (22) est formé sur un substrat semi-conducteur (21), et une première couche semi-conductrice (23) est formée sur ladite première couche isolante;
traiter ladite première couche semi-conductrice de façon à obtenir des dimensions planes prédéterminées;
former un second film isolant (24) sur les surfaces de sommet et de côté de ladite première couche semi-conductrice traitée (23₁);
déposer un troisième film isolant non oxydable (25) sur une surface majeure de ladite structure semi-conductrice (100);
déposer une seconde couche semi-conductrice (26) sur ledit troisième film isolant non oxydable (25);
former un quatrième film isolant (27) sur ladite seconde couche semi-conductrice (26);
déposer un cinquième film isolant non oxydable (28) sur ledit quatrième film isolant (27);
traiter ledit cinquième film isolant non oxydable (28), de façon à obtenir des dimensions couvrant la région de ladite première couche semi-conductrice traitée, de façon qu'elle présente des dimensions planes prédéterminées;
oxyder ladite seconde couche semi-conductrice en utilisant ledit cinquième film isolant non oxydable en tant que masque, transformant ainsi une région majeure en un oxyde semi-conducteur (29);
éliminer ledit cinquième film isolant non oxydable (28) et ledit quatrième film isolant (27₁), restant sous ledit cinquième film isolant non oxydable, de façon à exposer ladite seconde couche semi-conductrice (26₁) restant sous ledit quatrième film isolant;
attaquer ladite seconde couche semi-conductrice (26₁) de façon à exposer ledit troisième film isolant non oxydable (25) sur ladite première couche semi-conductrice traitée (23₂);
transformer ladite seconde couche semi-conductrice, restant partiellement sur la périphérie de ladite première couche semi-conductrice traitée (23₂), en un oxyde (30); et
attaquer ledit troisième film isolant non oxydable (25) exposé sur une surface majeure latérale de ladite structure semi-conductrice pour exposer ledit second film isolant (24).

5. Procédé selon la revendication 4, comprenant en outre les étapes consistant à :
transformer ladite première couche semi-conductrice en une couche active semi-cond uctrice (23₃) d'un premier type de conductivité;
éliminer ledit second film isolant (24) sur ladite couche active semi-conductrice, de façon à former un film oxyde de grille (31);
former une électrode de grille (32₁) sur ladite couche active semi-conductrice (23₃) et former une couche d'interconnexion pour connecter ladite électrode de grille à un autre élément;
former une couche isolante (35) sur ladite structure semi-conductrice; et
former une électrode source et une électrode drain connectées à une région source et une région drain, respectivement, à travers des trous de contact (35A, 35B) formés dans ladite couche isolante (35) et ledit film d'oxyde de grille disposé sous ladite couche isolante.

6. Procédé selon la revendication 4 ou 5, dans lequel, après traitement dudit cinquième film isolant non oxydable (28) pour lui donner des dimensions planes prédéterminées, on élimine ledit quatrième film isolant exposé pour exposer ladite seconde couche semi-conductrice (26) sous ledit quatrième film isolant.
